**Europäisches Patentamt**

**European Patent Office**

**Office européen des brevets**

(19)

(11) Veröffentlichungsnummer: **0 201 681**
**A2**

(12) **EUROPÄISCHE PATENTANMELDUNG**

(21) Anmeldenummer: **86103053.4**

(22) Anmeldetag: **07.03.86**

(51) Int. Cl.⁴: **H 03 J 7/18**

(30) Priorität: **17.05.85 DE 3517736**

(43) Veröffentlichungstag der Anmeldung:
**20.11.86 Patentblatt 86/47**

(84) Benannte Vertragsstaaten:
**CH DE FR IT LI**

(71) Anmelder: **GRUNDIG E.M.V. Elektro-Mechanische Versuchsanstalt Max Grundig holländ. Stiftung & Co. KG.**
**Kurgartenstrasse 37**
**D-8510 Fürth(DE)**

(72) Erfinder: **Baumgartner, Franz Xaver**
**Waldstrasse 9**
**D-8501 Siegelsdorf(DE)**

(54) **Mobil einsetzbarer Rundfunkempfänger mit verzögertem Suchlaufstart.**

(57) Bei einem mobil einsetzbaren Rundfunkempfänger mit einer Schwellwertschaltung zur Überwachung eines Feldstärke-und/oder Störsignalpegels, einer Verzögerungsschaltung zur Erzeugung eines vom Feldstärke- und/oder Störsignalpegel abhängigen und um eine vorgegebene Zeit verzögerten. Steuersignals sowie einer Sendersuchlaufeinrichtung ist eine Auswerteschaltung vorgesehen, die entweder den Bewegungszustand des Fahrzeugs oder den am Ort des Empfängers vorhandenen Feldstärke- und/oder Störspannungsverlauf ermittelt. Sie schaltet im stehenden Betrieb des Fahrzeugs oder bei einem konstanten Feldstärke- und/oder Störspannungsverlauf eine erste Zeitkonstante und im fahrenden Betrieb des Fahrzeugs oder bei einem schwankenden Feldstärke- und/oder Störspannungsverlauf eine zweite, gegenüber der ersten kleinere Zeitkonstante für die Verzögerung des Suchlaufstarts wirksam.

FIG.1

Croydon Printing Company Ltd.

MOBIL EINSETZBARER RUNDFUNKEMPFÄNGER
MIT VERZÖGERTEM SUCHLAUFSTART


BESCHREIBUNG:

Die Erfindung betrifft einen mobil einsetzbaren Rundfunkempfänger der im Oberbegriff des Anspruchs 1 oder 3
angegebenen Art.

Rundfunkempfänger mit automatischem, feldstärke- und/oder störspannungsabhängigem Sendersuchlauf sind bekannt. Bei ihnen erfolgt der Suchlaufstart nicht sofort beim Unterschreiten eines vorgegebenen Mindestfeldstärkepegels oder Überschreiten eines maximal zulässigen Störsignalpegels, sondern erst nach einer bestimmten zeitlichen Verzögerung, die üblicherweise bei etwa 30 Sekunden liegt. Ein derart langer Zeitablauf ist notwendig, damit der Suchlauf nicht unnötig gestartet wird, wenn das Fahrzeug beim Durchfahren eines gut versorgten Rundfunkgebietes vorübergehend in ein eng begrenztes Feldstärkeminimum gelangt. Dieser Fall kann insbesondere bei einem Ampelstop im Stadtverkehr eintreten.

Der Erfindung liegt die Erkenntnis zugrunde, daß sich der bekannte Rundfunkempfänger im Fahrbetrieb des Fahrzeugs als nachteilig erweist, da auch bei häufig auftretenden Feldstärkeeinbrüchen, die zeitlich nur wenig kürzer sind als die Verzögerungszeit von 30 Sekunden, der Suchlaufstart nicht ausgelöst wird. Dementsprechend liegt der Erfindung die Aufgabe zugrunde, einen mobil einsetzbaren Rundfunkempfänger der im Oberbegriff des Anspruchs 1 oder 3 angegebenen Art so auszubilden, daß die Steuerung des Zeitablaufs für den Start des Suchlaufs verbessert wird.

Diese Aufgabe wird gemäß der Erfindung durch die im kennzeichnenden Teil des Anspruchs 1 oder 3 angegebenen Merkmale gelöst. Eine vorteilhafte Ausgestaltung der Erfindung ist im Unteranspruch 2 gekennzeichnet.

Bei dem mobil einsetzbaren Rundfunkempfänger gemäß der Erfindung ist in vorteilhafter Weise eine Auswerteschaltung vorgesehen, die entweder den Bewegungszustand des Fahrzeugs oder den am jeweiligen Ort des Fahrzeugs bzw. Empfängers vorhandenen Feldstärke- und/oder Störspannungsverlauf ermittelt. In Abhängigkeit hiervon werden verschieden große Zeitkonstanten für die Verzögerung des Suchlaufstarts wirksam geschaltet, die jeweils so gewählt sind, daß eine vorzeitige oder zu späte Aktivierung des automatischen Suchlaufs vermieden wird. Damit ergibt sich der Vorteil, daß der auto-

- 3 -

matische Suchlauf bei einzelnen, örtlich eng begrenzt
auftretenden Empfangsstörungen, die sich insbesondere
im stehenden Betrieb des Fahrzeugs bemerkbar machen,
nicht zu früh und bei häufig, im Fahrbetrieb in Erscheinung tretenden Empfangsstörungen nicht zu spät
startet.

Bei einer bevorzugten Ausführungsform der Erfindung wird
als Kriterium für den Bewegungszustand des Fahrzeugs
und die Wahl der Startverzögerung für den Suchlauf die
Tachospannung des Fahrzeugtachometers ausgewertet.

Ausführungsbeispiele der Erfindung sind im folgenden
anhand von Zeichnungen näher erläutert. Es zeigen:

Fig. 1   ein Blockschaltbild eines Rundfunkempfängers
         mit einer vom Bewegungszustand des Fahrzeugs
         abhängigen Startverzögerung des Suchlaufs gemäß
         der Erfindung.

Fig. 2   ein Blockschaltbild eines Rundfunkempfängers
         mit einer vom Verlauf der Feldstärke und/oder
         der Störspannung abhängigen Startverzögerung
         des Suchlaufs gemäß der Erfindung.

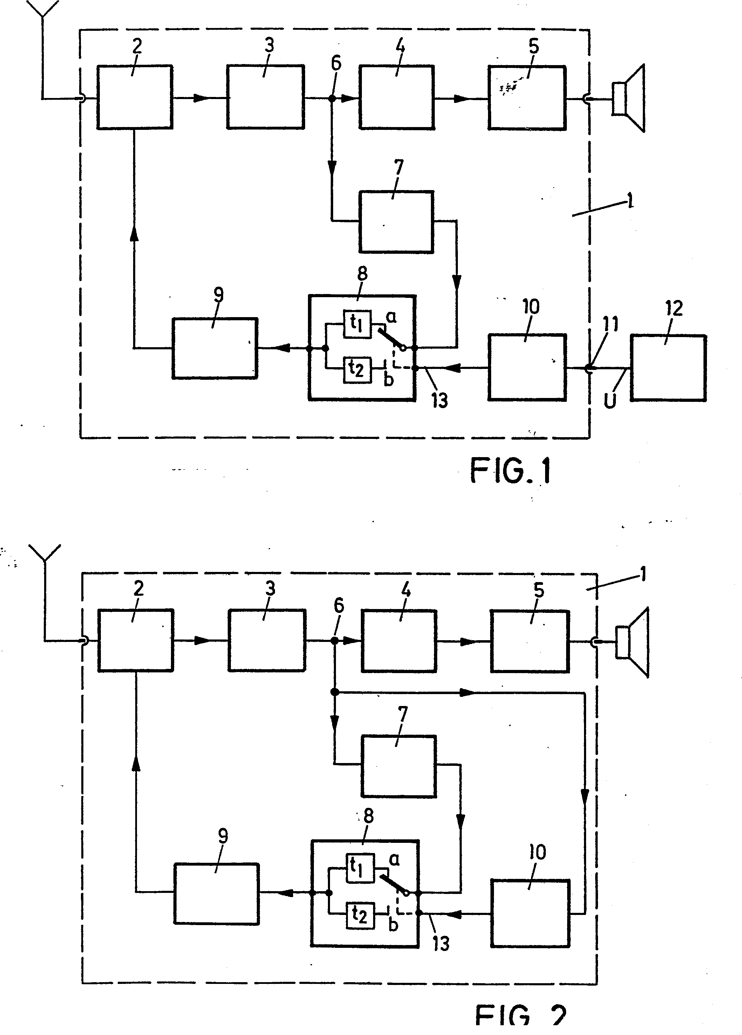

Die Ausführungsbeispiele nach Fig. 1 und 2 geben jeweils
den prinzipiellen Schaltungsaufbau wieder, der zur Erläuterung der Erfindung erforderlich ist.

Die in Fig. 1 dargestellte Empfangsschaltung 1 weist einen Tuner 2, einen ZF-Verstärker 3, einen Demodulator 4, einen NF-Verstärker 5 und ferner eine mit dem ZF-Ausgang 6 in Verbindung stehende Schwellwertschaltung 7 auf, die ihrerseits über eine Verzögerungsschaltung 8 mit einer den Tuner 2 steuernden, automatischen Sendersuchlaufeinrichtung 9 verbunden ist. Weiterhin ist der Empfänger 1 mit einer Auswerteschaltung 10 ausgestattet, die eingangsseitig über einen externen Anschluß 11 an den eine Tachospannung U liefernden Tachometer 12 eines Fahrzeugs anschließbar ist. Der Ausgang der Auswerteschaltung 10 liegt an einem Schalteingang 13 der Verzögerungsschaltung 8.

Im stehenden Betrieb des Fahrzeugs erkennt die Auswerteschaltung 10 an ihrem Eingang die Tachospannung $U = 0$, bei der über den Schalteingang 13 der Verzögerungsschaltung 8 die Zeitkonstante $t_1$ wirksam geschaltet wird (Schalterstellung a). Die Zeitkonstante $t_1$ ist so gewählt, daß zum Beispiel bei einem Ampelstop und einem gleichzeitigen Abfall des Feldstärkepegels unter einen vorgegebenen Mindestwert oder einem gleichzeitigen Anstieg des vor allem durch Mehrwegeempfang verursachten Störpegels über einen gleichfalls vorgegebenen zulässigen Höchstwert der Suchlaufstart entsprechend lange verzögert wird, da in einem gut versorgten Rundfunkgebiet nach Beendigung des Ampelstops wieder ein störungsfreier Empfang des gewünschten Senders möglich ist. Das zu verzögernde, schwellwertabhängige Steuersignal für die Sendersuchlaufeinrichtung 9 wird von der Schwellwertschaltung 7 geliefert, die die Nutz- und/oder Störanteile des ZF-Signals nach ihrer Größe überwacht und auswertet. Ist das Fahrzeug wieder in Bewegung, so wird am Eingang 11 der Auswerteschaltung 10 eine Tachospannung $U \neq 0$ erzeugt. Durch sie wird bei der Verzögerungsschaltung 8 eine gegenüber der Zeitkonstanten $t_1$ kürzere Zeitkonstante $t_2$ wirksam geschaltet (Schalterstellung b). Hieraus ergibt sich eine Verkürzung des Zeitablaufs bis zum Start des Suchlaufs, und zwar derart, daß bereits kurzzeitigere Feldstärkeeinbrüche oder Störspannungsüberhöhungen, die bei häufigerem Auftreten störend wirken, einen Suchlaufstart auslösen.

Bei dem mobil einsetzbaren Rundfunkempfänger gemäß Fig. 2 wird zur Umschaltung der Zeitkonstanten für die Verzögerung des Suchlaufstarts nicht wie im ersten Ausführungsbeispiel der Bewegungszustand des Fahrzeugs ausgewertet, sondern der am Ort des Empfängers vorhandene Feldstärke- und/oder Störspannungsverlauf. Dies hat den Vorteil, daß ein zusätzlicher externer Anschluß zum Anlegen der Tachospannung U entfallen kann. Stattdessen wird der Auswerteschaltung 10 das am ZF-Ausgang 6 abgreifbare Signal zugeführt. Ergibt sich bei seiner Auswertung ein konstanter Feldstärke- und/oder Störspannungsverlauf, dann wird die größere Zeitkonstante $t_1$ wirksam geschaltet. Andernfalls, also bei einem schwankenden Feldstärke- und/oder Störspannungsverlauf, wird für die Verzögerung des Suchlaufstarts die kleinere Zeitkonstante $t_2$ gewählt. Ein schwankender Feldstärkeverlauf ergibt sich

- ( -

zum Beispiel bei einem fahrenden Fahrzeug innerhalb
eines Gebietes mit schlechter HF-Versorgung. Dagegen
tritt bei einem stehenden Fahrzeug, bei sehr guter
HF-Versorgung oder beim Durchfahren von Tunnels ein
jeweils konstanter Feldstärkeverlauf auf.

MOBIL EINSETZBARER RUNDFUNKEMPFÄNGER
MIT VERZÖGERTEM SUCHLAUFSTART


PATENTANSPRÜCHE:


1. Mobil einsetzbarer Rundfunkempfänger mit einer Schwellwertschaltung, die beim Empfang eines Senders dessen Feldstärkepegel und/oder den durch Mehrwegeempfang verursachten Störsignalpegel überwacht, mit einer mit der Schwellwertschaltung in Verbindung stehenden Verzögerungsschaltung, die beim Unterschreiten eines Mindestfeldstärkepegels oder Überschreiten eines maximal zulässigen Störsignalpegels ein um eine vorgegebene Zeit verzögertes Steuersignal erzeugt, sowie mit einer mit der Verzögerungsschaltung in Verbindung stehenden Sendersuchlaufeinrichtung, die beim Anliegen des verzögerten Steuersignals gestartet wird, d a d u r c h g e k e n n z e i c h n e t , daß eine Auswerteschaltung (10) vorgesehen ist, die den Bewegungszustand des Fahrzeugs ermittelt und die bei der Verzögerungsschaltung (8) im stehenden Betrieb des Fahrzeugs eine erste Zeitkonstante ($t_1$) und im fahrenden Betrieb des Fahrzeugs eine zweite, gegenüber der ersten kleinere Zeitkonstante ($t_2$) für die Verzögerung des Suchlaufstarts wirksam schaltet.

2. Rundfunkempfänger nach Anspruch 1, d a d u r c h g e k e n n z e i c h n e t , daß der Auswerteschaltung (10) die Tachospannung (U) eines Meßinstruments (12) für die Fahrzeuggeschwindigkeit zugeführt wird.

3. Mobil einsetzbarer Rundfunkempfänger mit einer Schwellwertschaltung, die beim Empfang eines Senders dessen Feldstärkepegel und/oder den durch Mehrwegeempfang verursachten Störsignalpegel überwacht, mit einer mit der Schwellwertschaltung in Verbindung stehenden Verzögerungsschaltung, die beim Unterschreiten eines Mindestfeldstärkepegels oder Überschreiten eines maximal zulässigen Störsignalpegels ein um eine vorgegebene Zeit verzögertes Steuersignal erzeugt, sowie mit einer mit der Verzögerungsschaltung in Verbindung stehenden Sendersuchlaufeinrichtung, die beim Anliegen des verzögerten Steuersignals gestartet wird, d a d u r c h g e k e n n z e i c h n e t , daß eine Auswerteschaltung (10) vorgesehen ist, die den ortsabhängigen Feldstärke- und/oder Störspannungsverlauf ermittelt und die bei der Verzögerungsschaltung (8) im Falle eines konstanten Feldstärke- und/oder Störspannungsverlaufs eine erste Zeitkonstante ($t_1$) und im Falle eines schwankenden Feldstärke- und/oder Störspannungsverlaufs eine zweite, gegenüber der ersten kleinere Zeitkonstante ($t_2$) für die Verzögerung des Suchlaufstarts wirksam schaltet.

0201681

Reg. 1999

FIG.1

FIG 2